# EUROPEAN PATENT APPLICATION

(11) **EP 3 528 293 A1**
(43) Date of publication of application: **21.08.2019**
(21) Application number: 18750093.9
(22) Date of filing: 03.07.2018
(51) Int. Cl.: H01L 31/046

(54) **THIN-FILM SOLAR CELL AND FABRICATION METHOD THEREFOR**

(30) Priority: 22.12.2017 CN 201711408069
(71) Applicant: Beijing Apollo Dingrong Solar Technology Co., Ltd, Beijing 100176 (CN)
(72) Inventor: LI, Xinlan, Beijing 100176 (CN)
(74) Representative: Prüfer & Partner mbB Patentanwälte · Rechtsanwälte
(86) International application number: PCT/CN2018/094328
(87) International publication number: WO 2019/119774

(57) **Abstract**

The present disclosure relates to a thin film solar cell and a method for making the same. The thin film solar cell comprises a substrate and a back electrode layer, a light absorbing layer, a buffer layer, a window layer and an upper electrode disposed on the substrate; and a surface of the light absorbing layer comprises a light trapping structure.

## Description

### Cross-Reference to Related Applications

The present application claims the benefit of priority to Chinese Patent Application No. 201711408069.8, entitled "Thin Film Solar Cell and Method for Making the Same" and filed on December 22, 2017 in the State Intellectual Property Office of China, the entire content of which is herein incorporated by reference.

### Technical Field

The present disclosure relates to a thin film solar cell and a method for making the same.

### Background Art

A thin film solar cell, also known as a "solar chip" or a "photovoltaic cell", is an optoelectronic semiconductor film that directly generates electricity by utilizing sunlight. A copper indium gallium selenide (CIGS) thin film solar cell is a heterojunction photovoltaic cell composed of a p-type copper indium gallium selenide layer, a CdS buffer layer, and a ZnO/AZO layer. CIGS thin film solar cell has advantages of high light-absorption capability, low manufacturing cost, capability of being flexible, stable power generation, and environmental friendliness. It is one of the most likely materials to replace silicon cells in the future.

At present, a highest conversion efficiency of the CIGS thin film solar cell has exceeded 22% in the laboratory. A typical method for making the CIGS thin film solar cell comprises: using an ordinary soda-lime glass or a flexible material as a substrate; depositing a Mo layer as a back electrode layer on the substrate by a magnetron sputtering method; using a selenization method after a co-evaporation or a sputtering to prepare a CIGS light absorbing layer; making a CdS buffer layer by a chemical water bath method, and sequentially depositing an i-ZnO layer and a transparent electrode layer (such as s AZO layer) by a magnetron sputtering method, thereby forming a p-n structure.

In the process of making each functional film layer, a plurality of sub-cells is formed and connected in series or in parallel by P1/P2/P3 scribing. Wherein, in order to facilitate formation of the plurality of sub-cells, after the back electrode layer, such as the Mo layer, is deposited, the entire Mo layer is laser-scribed to form a P1 scribed line, so that the entire Mo layer is divided into a plurality of sub-modules. After that the light absorbing layer (such as the CIGS layer) and the buffer layer (such as the CdS layer) are formed. The CIGS layer and the CdS layer are laser-scribed or mechanically scribed to form a P2 scribed line, so that a channel to connect the plurality of sub-cells in series is formed. The intrinsic i-ZnO layer and the transparent electrode layer are sequentially deposited after the P2 scribing. Then, all layers disposed on the Mo layer are laser-scribed or mechanically scribed to form a P3 scribed line parallel to the P1/P2 scribed line.

At present, light absorption can be improved by forming some protrusions or depressions, i.e. a light trapping structure, on a surface of a film layer. The light trapping structure of the thin film solar cell is usually obtained by the following methods:
1) using a glass whose surface is provided with a plurality of protrusions having a specific shape as a substrate, and forming a solar cell having the light trapping structure through a series of coating processes;
2) forming a concave-convex light-trapping structure on the back electrode layer by a process such as a chemical etching method.

The above methods have some issues: in the method 1), due to the uneven structure of the substrate, the back electrode layer formed on the surface of the substrate is also uneven; in the method 2), since the back electrode layer has a concave-convex structure, when the P1 scribing, the P2 scribing, and the P3 scribing are respectively applied to the back electrode layer, it is difficult to obtain a uniform laser- or mechanical P1 scribing, and it is also very easy to cause a residual of the film layers such as the light absorbing layer, or the film layers are easy to be scribed too much during the P2 scribing and the P3 scribing.

### Summary

In view of this, the present disclosure provides a thin film solar cell and a method for making the same. A light absorbing layer of the thin film solar cell has a light trapping structure so that a photoelectric conversion efficiency of the thin film solar cell can be greatly improved. In the method for making the thin film solar cell, by disposing a light trapping structure on the light absorbing layer, a good scribing effect can be obtained in P1 scribing, P2 scribing, and P3 scribing processes.

The thin film solar cell provided in the present disclosure comprises a substrate and a back electrode layer, a light absorbing layer, a buffer layer, a window layer, and an upper electrode disposed on the substrate. A surface of the light absorbing layer comprises a light trapping structure which comprises a plurality of convex structures spaced from each other.

The making method provided in the present disclosure comprises the following steps:
a) providing a substrate and forming a back electrode layer on the substrate;
b) forming a light absorbing layer having a light trapping structure on the back electrode layer, wherein the light absorbing structure comprises a plurality of convex structures spaced from each other; and
c) sequentially forming a buffer layer, a window layer, and an upper electrode layer on the light absorbing layer having the light trapping structure.

The thin film solar cell and the method for making the same have the following advantages. The light trapping structure which comprises the plurality of convex structures spaced from each other is provided on the surface of the light absorbing layer. Therefore, on one hand, compared to the prior art in which a concave-convex light trapping structure is formed on the substrate or on the back electrode layer, the light trapping structure is formed on the light absorbing layer in the present disclosure, thereby avoiding the unevenness of the substrate or the back electrode layer. That is, at least the substrate and the back electrode layer have flat surfaces, so that a uniform P1 scribing can be obtained. In addition, since all the layers disposed on the back electrode layer are scribed in the P2 scribing and the P3 scribing, the effects of the P2 scribing and the P3 scribing are not influenced by the light trapping structure, and the short-circuiting of the solar cell caused by the residual of the light absorbing layer and poor appearance due to partial excessive scribing are avoided. On the other hand, due to the convex structure, the incident light can be dispersed to various angles, thereby increasing the optical path length of the light in the light absorbing layer, increasing the absorption of light, and ultimately improving the short-circuit current and photoelectric conversion efficiency of the solar cell. The method for making the thin film solar cell has advantages of simple process, high efficiency and controllability.

### Brief Description of Drawings

FIG. 1 is a schematic structural view of a thin film solar cell of the present disclosure;
FIG. 2 is a schematic structural view of a light absorbing layer of the thin film solar cell shown in FIG. 1;
FIG. 3 is a scanning electron microscope (SEM) photograph of a light absorbing layer of a thin film solar cell of Example 1;
FIG. 4 is a schematic structural view of a light absorbing layer of a thin film solar cell of Example 3;
FIG. 5 is a schematic structural view of a light absorbing layer of a thin film solar cell of Example 4;
FIG. 6 to FIG. 10 are respectively a schematic structural view of one embodiment of a convex structure of the present disclosure.
FIG. 11 is a SEM photograph of a light absorbing layer of a thin film solar cell of a Comparative Example.

In the drawings, 10 represents a substrate; 20 represents a back electrode layer; 30 represents a light absorbing layer; 300 represents a light trapping structure; 301 represents a convex structure; 40 represents a buffer layer; 50 represents a window layer; 60 represents an upper electrode layer.

### Detailed Description

The following gives a clear and complete description to the technical solution of embodiments of the present disclosure. Apparently, the described embodiments are merely part and not all of embodiments of the present disclosure. Other embodiments obtained based on the embodiments of the present disclosure without creative work by those ordinary skilled in the art shall fall within the protection scope of the present disclosure.

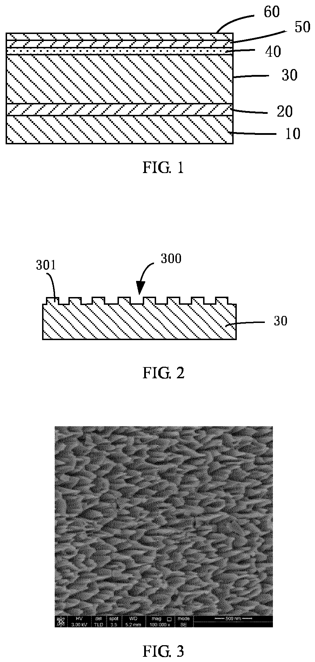

Referring to FIG. 1, the present disclosure provides a thin film solar cell. The thin film solar cell comprises a substrate 10, and a back electrode layer 20, a light absorbing layer 30, a buffer layer 40, a window layer 50, and an upper electrode layer 60 disposed on the substrate 10. Referring to FIG. 2, a surface of the light absorbing layer 30 comprises a light trapping structure 300.

A material of the substrate 10 is not limited and can be a glass, a stainless steel, or a flexible material. A thickness of the substrate 10 is also not limited. The substrate 10 is used as a supporter.

A material of the back electrode layer 20 can be one of metals Mo, Ti, Cr, and Cu or one of transparent conductive layer materials AZO, BZO, and ITO. A thickness of the back electrode layer 20 is not limited. In one embodiment, the back electrode layer 20 can have a thickness of 200 nm to 800 nm.

A material of the light absorbing layer 30 is one of copper indium gallium selenide, copper indium selenide, and copper indium gallium sulfide. A thickness of the light absorbing layer 30 is not limited. In one embodiment, the light absorbing layer 30 can have a thickness of 0.5 µm to 3 µm.

An optical path length of light in the light absorbing layer can be increased by disposing the light trapping structure 300, thereby improving the light absorption capability, and ultimately improving the short circuit current and the photoelectric conversion efficiency of the solar cell. The light trapping structure 300 and the light absorbing layer 30 are integrated to form a one piece structure, which means that materials of the light trapping structure 300 and the light absorbing layer 30 are same, and an indivisible integral structure is formed by the light trapping structure 300 and the light absorbing layer 30 . With respect to the preparation method, the light trap structure 300 can be formed by the following two methods: 1) forming the light absorbing layer 30 and etching the light absorbing layer 30 by ion etching method or mechanical etching method to form the light trapping structure 300 on the surface of the light absorbing layer 30; 2) forming the light trapping structure 300 by a mask deposition method.

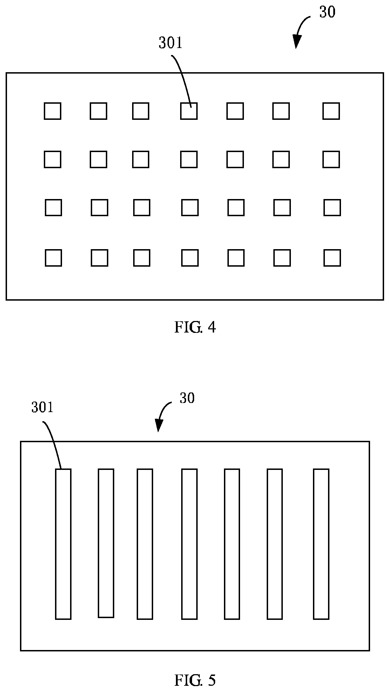

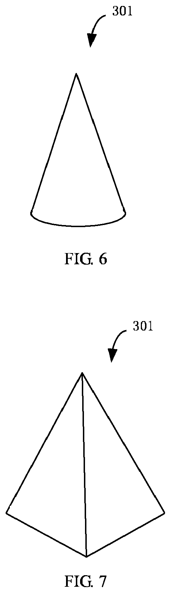

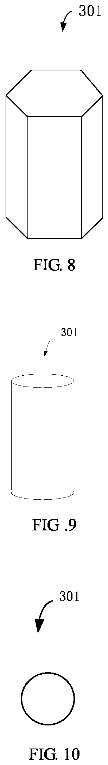

A shape and an arrangement of the light trapping structure 300 are not limited. Referring to FIG. 2, the light trapping structure 300 can comprises a plurality of convex structures 301 spaced from each other. The plurality of convex structures 301 in the light trapping structure 300 are spaced apart from each other. The plurality of convex structures 301 can be arranged in a form of a two-dimensional dot matrix as shown in FIG. 4, a one-dimensional array as shown in FIG. 5, or other irregular patterns. The convex structure 301 can be at least one of a conical structure as shown in FIG. 6, a tetrahedral structure as shown in FIG. 7, a hexagonal prism as shown in FIG. 8, a cylinder as shown in FIG. 9, a spherical structure as shown in FIG. 10, a square prism as shown in FIG. 4, and a protruded ridge structure as shown in FIG. 5. Considering the etching process and the photoelectric conversion efficiency of the solar cell, in one embodiment, the convex structure 301 is a conical structure and the plurality of convex structures 301 are arranged in the form of dot matrix.

A material of the buffer layer 40 is one of zinc sulfide, cadmium sulfide, and indium sulfide. A thickness of the buffer layer 40 is not limited. In one embodiment, the buffer layer 40 can have a thickness of 30 nm to 100 nm.

A material of the window layer 50 is one of zinc oxide, indium oxide, and tin oxide. A thickness of the window layer 50 is not limited. In one embodiment, the window layer 50 can have a thickness of 30 nm to 200 nm.

A material of the upper electrode layer 60 is one of the transparent conductive layer materials AZO, BZO, and ITO. A thickness of the upper electrode layer 60 is not limited. In one embodiment, the upper electrode layer 60 can have a thickness of 100 nm to 1 µm.

The present disclosure also provides a method for making the thin film solar cell. The method comprises the following steps:
a) providing the substrate 10 and forming the back electrode layer 20 on the substrate 10;
b) forming the light absorbing layer 30 having the light trapping structure 300 on the back electrode layer 20; and
c) forming the buffer layer 40, the window layer 50, and the upper electrode layer 60 on the light absorbing layer 30 having the light trapping structure 300 sequentially.

In the step a), the back electrode layer can be formed by a chemical vapor deposition method, a magnetron sputtering method, an atomic layer deposition method, or the like.

In the step b), the light trapping structure 300 comprises the plurality of convex structures 301 spaced from each other. The light absorbing layer 30 having the light trapping structure 300 can be formed on the back electrode layer 20 by an additive mask deposition method, a subtractive ion etching method, or a subtractive mechanical etching method.

The light absorbing layer can be etched by one of a plasma etching method, a mechanical etching method, and a chemical wet etching method. In view of the process operability, the light absorbing layer 30 having the light trapping structure 300 is formed by the plasma etching method. In the plasma etching method to etch the light absorbing layer, a gas to form the plasma is Ar, N₂, an acceleration voltage of the plasma is in a range from 100V to 5kV, and an etching time is in a range from 0.5 minutes to 20 minutes.

The mask deposition method to form the light trapping structure 300 comprises: depositing a lower half of the light absorbing layer, i.e. a first absorbing layer, with a thickness of D₁ at first; then providing a mask and depositing an upper half of the light absorbing layer, i.e. a second absorbing layer, which is also the light trapping structure 300, with a thickness of D₂ through the mask; and then removing the mask. The shape and arrangement of the plurality of convex structures can be designed by patterns of the mask. A height of the convex structure is related to the thickness D₂. In one embodiment, D₁ is in a range from 500 nm to 3000 nm, and D₂ is in a range from 10 nm to 500 nm.

A distribution density of the plurality of convex structures 301 is in a range from 10⁸ pieces (pcs)/cm² to 10¹⁵ pcs/cm². In one embodiment, in order to obtain a higher light absorption efficiency, the distribution density of the convex structures is in a range from 5×10¹⁰ pcs/cm² to 10¹² pcs/cm².

The height of the convex structure is in a range from 10 nm to 500 nm. The shape of the convex structure 301 is not limited. A size of the convex structure is in a range from 20 nm to 200 nm. Taking the surface of the light absorbing layer as a horizontal plane, the size of the convex structure 301 refers to a maximum width, a maximum length, or a maximum diameter of a transverse cross section of the convex structure 301 along the horizontal plane, and it can also be considered as a size of a "root" of the convex structure 301 close to the light absorbing layer 30.

It should be noted that since the light trapping structure 300 is provided on the surface of the light absorbing layer, surfaces of the buffer layer, the window layer, and the upper electrode layer subsequently formed on the surface of the light absorbing layer can also have a concave-convex shape, but each layer is an integrated layered structure, which does not affect the subsequent P1 scribing. That is, at least the surface of the back electrode layer is a flat surface, so that an uniform flat scribing effect can still be obtained in the P1 scribing.

The thin film solar cell and the method for making the same have the following advantages. The light trapping structure 300 which comprises the plurality of convex structures 301 spaced from each other is provided on the surface of the light absorbing layer 30. On one hand, compared to the prior art in which a concave-convex light trapping structure 300 is formed on the substrate or on the back electrode layer, the light trapping structure 300 is formed on the light absorbing layer in the present disclosure, thereby avoiding the unevenness of the substrate or the back electrode layer. That is, at least the substrate and the back electrode layer have flat surfaces, so that a uniform P1 scribing can be obtained. In addition, since all the layers disposed on the back electrode layer are scribed in the P2 scribing and the P3 scribing, the effects of the P2 scribing and the P3 scribing are not influenced by the light trapping structure 300, and the short-circuiting of the solar cell caused by the residual of the light absorbing layer and poor appearance due to partial excessive scribing are avoided. On the other hand, due to the convex structure 301, the incident light can be dispersed to various angles, thereby increasing the optical path length of the light in the light absorbing layer, increasing the absorption of light, and ultimately improving the short-circuit current and photoelectric conversion efficiency of the solar cell. The method for making the thin film solar cell has advantages of simple process, high efficiency and controllability.

Hereinafter, the thin film solar cell and the method for making the same will be further described by the following specific examples.

### Example 1

A method for making a thin film solar cell is as follows:
a) A substrate is provided and a back electrode layer is formed on the substrate by a magnetron sputtering method, wherein a material of the substrate is a glass, and the back electrode layer is a metal Mo layer. In the magnetron sputtering method, argon gas is used as a gas source, metal Mo is used as a target, and a vacuum degree is in a range from 0.1 Pa to 0.7 Pa.
b) A light absorbing layer having a thickness of about 3 µm is formed on the back electrode layer by a co-evaporation method, and then a light trapping structure is formed by a plasma etching method. Wherein, the light trapping structure is a plurality of conical structures spaced from each other. In the co-evaporation process, a temperature of the substrate is raised to about 500 °C in a vacuum environment, and a copper source, an indium source, and a gallium source are heated to be evaporated under a Se atmosphere and reacted on the substrate to form a CIGS film having a thickness of about 3 µm, i.e. a copper indium gallium selenide light absorbing layer 30, wherein Cu/(In+Ga)=0.9, Ga/(In+Ga)=0.3. In the plasma etching method, an ion source is Ar⁺, an acceleration voltage is about 3 kV, and an etching time is 5 minutes.
c) The buffer layer, the window layer and the upper electrode layer are deposited sequentially on the light absorbing layer having the light trapping structure. The buffer layer is a cadmium sulfide layer having a thickness of about 80 nm, the window layer is a zinc oxide layer having a thickness of about 50 nm, and the upper electrode layer is an AZO transparent conductive film having a thickness of about 30 µm.

A morphology characterization of the CIGS layer of the obtained thin film solar cell is tested, and the results are shown in FIG. 3. As it can be seen from FIG. 3, the surface of the light absorbing layer in the thin film solar cell has a plurality of conical structures spaced from each other. A height of the conical structure is in a range from about 150 nm to 250 nm.

The battery performance of the obtained thin film solar cell is tested, and the results are shown in Table 1.

### Example 2

A method for making a thin film solar cell is as follows:
a) A substrate is provided and a back electrode layer is formed on the substrate by a magnetron sputtering method, wherein a material of the substrate is a glass, and the back electrode layer is a metal Mo layer;
b) A light absorbing layer is formed on the back electrode layer by a co-deposition method and a light trapping structure is formed by a plasma etching method, wherein the light trapping structure is a plurality of conical structures spaced from each other. An ion source in the plasma etching method is Ar⁺; an acceleration voltage is about 800V; and an etching time is 8 minutes.
c) A buffer layer, a window layer and an upper electrode layer are formed sequentially on the light absorbing layer having the light trapping structure, wherein the buffer layer is a cadmium sulfide layer, the window layer is a zinc oxide layer, and the upper electrode layer is an AZO transparent conductive film.

The method for making the thin film solar cell of Example 2 is substantially the same as that of Example 1, except that the etching times and the acceleration voltages in the step b) are different.

A morphology characterization of the obtained thin film solar cell is tested, and the result shows that the surface of the light absorbing layer in the thin film solar cell has a plurality of conical structures spaced from each other. A height of the conical structure is about 30 nm to 100 nm.

The battery performance of the obtained thin film solar cell is tested, and the results are shown in Table 1.

### Example 3

A method for making a thin film solar cell is as follows:
a) A substrate is provided and a back electrode layer is formed on the substrate by a magnetron sputtering method, wherein a material of the substrate is a glass, the back electrode layer is a metal Ti layer;
b) A light absorbing layer is formed on the back electrode layer by a co-deposition method, wherein the co-deposition process is performed in two stages: firstly, a 2.5 µm of CIGS layer is obtained by depositing for 20 minutes; then a mask with a dot matrix pattern is provided and a plurality of columnar convex structures arranged in the form of dot matrix (as shown in FIG. 4) is formed by depositing for another 5 minutes through the mask;
c) A buffer layer, a window layer and an upper electrode layer are formed sequentially on the light absorbing layer having the light trapping structure, wherein the buffer layer is a cadmium sulfide layer, the window layer is a zinc oxide layer, and the upper electrode layer is an AZO transparent conductive film.

The method for making the thin film solar cell of Example 3 is substantially the same as that of Example 1, except that the methods for forming the light trapping structure in the step b) are different.

A morphology characterization of the obtained thin film solar cell is tested, and the results shows that the surface of the light absorbing layer in the thin film solar cell has a plurality of columnar structures spaced from each other. A height of the columnar structure is about 150 nm to 200 nm.

The battery performance of the obtained thin film solar cell is tested, and the results are shown in Table 1.

### Example 4

A method for making a thin film solar cell is as follows:
a) A substrate is provided and a back electrode layer is formed on the substrate by a magnetron sputtering method, wherein the material of the substrate is a glass, and the back electrode layer is a metal Ti layer.
b) A light absorbing layer is formed on the back electrode layer by a co-deposition method, and the co-deposition process is performed in two stages: firstly, a 2.5µm of CIGS layer is obtained by depositing for 20 minutes; then a mask with a groove pattern is provided and a plurality of protruded ridge structures arranged in the form of a one dimensional array (as shown in FIG. 5) is formed by depositing for another 5 minutes through the mask.
c) A buffer layer, a window layer and an upper electrode layer are formed sequentially on the light absorbing layer having the light trapping structure, wherein the buffer layer is a cadmium sulfide layer, the window layer is a zinc oxide layer, and the upper electrode layer is an AZO transparent conductive film.

The method for making the thin film solar cell of Example 4 is substantially the same as that of Example 3, except that the patterns on the masks used to form the light trapping structure are different.

A morphology characterization of the obtained thin film solar cell is tested, and the results shows that the surface of the light absorbing layer in the thin film solar cell has a plurality of strip-like convex structures spaced from each other. A height of the strip-like convex structures is about 150 nm to 200 nm.

The battery performance of the obtained thin film solar cell is tested, and the results are shown in Table 1.

In order to illustrate the excellent performance of the thin film solar cell of the present disclosure better, a Comparative Example is also provided.

### Comparative Example

A method for making a thin film solar cell is as follows:
a) A substrate is provided and a back electrode layer id formed on the substrate by a magnetron sputtering method, wherein a material of the substrate is a glass, the back electrode layer is a metal Mo layer.
b) A light absorbing layer having a thickness of about 3 µm is formed on the back electrode layer by a co-deposition method;
c) A buffer layer, a window layer and an upper electrode layer are deposited sequentially on the light absorbing layer having the light trapping structure. The buffer layer is a cadmium sulfide layer having a thickness of about 80 nm. The window layer is a zinc oxide layer having a thickness of about 50 nm. The upper electrode layer is an AZO transparent conductive film having a thickness of about 30 µm.

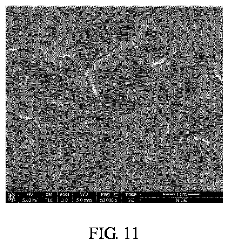

A morphology characterization of the obtained thin film solar cell is tested, and the result is shown in FIG. 11. As it can be seen from FIG. 11, the surface of the light absorbing layer in the thin film solar cell has a relatively plat surface.

The battery performance of the obtained thin film solar cell is tested, and the results are shown in Table 1.

**Table 1**

| | Short circuit current density mA/cm² | Photoelectric conversion efficiency (%) |
|---|---|---|
| Example 1 | 29.7 | 14.9 |
| Example 2 | 31.2 | 15.7 |
| Example 3 | 30.1 | 15.1 |
| Example 4 | 30.3 | 15.2 |
| Comparative Example | 29.3 | 14.7 |

It can be seen from Table 1 that the photoelectric conversion efficiency and the short circuit current of thin film solar cells of Examples 1 to 4 of the present disclosure are greatly improved compared to the Comparative Example. In particular, since the thin film solar cell of Example 2 has a light trapping structure having a special conical shape, the optical path length can be greatly improved, thereby greatly improving the photoelectric conversion efficiency.

It will be readily understood by those skilled in the art that the above various preferred embodiments can be freely combined and superimposed without conflict.

It should be understood that the embodiments described above is illustrative and not restrictive. Modifications or substitutions obtained by those skilled in the art according to the above-described details are intended to be included within the scope of the appended claims.

## Claims

1. A thin film solar cell, comprising:
a substrate; and
a back electrode layer, a light-absorbing layer, a buffer layer, a window layer, and an upper electrode disposed on the substrate;
**characterized in that** a surface of the light absorbing layer comprises a light trapping structure.

2. The thin film solar cell of claim 1, **characterized in that**, the light trapping structure comprises a plurality of convex structures spaced from each other.

3. The thin film solar cell of claim 2, **characterized in that**, the convex structure is at least one of a conical structure, a tetrahedral structure, a prism, a protruded ridge, and a spherical structure.

4. The thin film solar cell of claim 3, **characterized in that**, the plurality of convex structures is a plurality of conical structures arranged in the form of a dot matrix.

5. The thin film solar cell of claim 2, **characterized in that**, a distribution density of the plurality of convex structures is in a range from 10⁸ pcs/cm² to 10¹⁵ pcs/cm².

6. The thin film solar cell of claim 5, **characterized in that**, the distribution density of the plurality of convex structures is in a range from 5×10¹⁰ pcs/cm² to 10¹² pcs/cm².

7. The thin film solar cell of claim 2, **characterized in that**, a height of the convex structure is in a range from 10 nm to 500 nm.

8. The thin film solar cell of claim 7, **characterized in that**, the height of the convex structure is in a range from 20 nm to 200 nm.

9. The thin film solar cell of claim 1, **characterized in that**, the light trapping structure and the light absorbing layer are integrated into a one piece structure.

10. A method for making a thin film solar cell, **characterized by** comprising:
a) providing a substrate and forming a back electrode layer on the substrate;
b) forming a light absorbing layer having a light trapping structure on the back electrode layer; and
c) forming a buffer layer, a window layer, and an upper electrode layer sequentially on the light absorbing layer having the light trapping structure.

11. The method for making the thin film solar cell claim 10, **characterized in that**, the step b) comprises:
forming the light absorbing layer on a surface of the back electrode layer, and
etching the light absorbing layer to form a plurality of convex structures spaced from each other.

12. The method for making the thin film solar cell of claim 11, **characterized in that**, a method for etching the light absorbing layer is one of a plasma etching method, a mechanical etching method, and a chemical wet etching method.

13. The method for making the thin film solar cell of claim 12, **characterized in that**, in the plasma etching method, plasma is formed from Ar or N₂, an acceleration voltage of the plasma is in a range from 100V to 5kV, and an etching time is in a range from 0.5 minutes to 20 minutes.

14. The method for making the thin film solar cell of claim 10, **characterized in that**, the step b) comprises:
depositing the light absorbing layer on the back electrode layer, wherein a depositing process of the light absorbing layer comprises:
depositing a first absorbing layer with a thickness of D₁; and
providing a mask and depositing a second absorbing layer with a thickness of D₂ through the mask to form the light absorbing layer having a plurality of convex structures spaced from each other, wherein the thickness D₁ is in a range from 500 nm to 3000 nm and the thickness D₂ is in a range from 10 nm to 500 nm.

15. The method for making the thin film solar cell of claim 10, **characterized in that**, the light trapping structure comprises a plurality of convex structures spaced from each other.

16. The method for making the thin film solar cell of claim 15, **characterized in that**, the convex structure is at least one of a conical structure, a tetrahedral structure, a prism, a protruded ridge, and a spherical structure.

17. The method for making the thin film solar cell of claim 15, **characterized in that**, a distribution density of the plurality of convex structures is in a range from 10⁸ pcs/cm² to 10¹⁵ pcs/cm².

18. The method for making the thin film solar cell of claim 17, **characterized in that**, the distribution density of the plurality of convex structures is in a range from 5×10¹⁰ pcs/cm² to 10¹² pcs/cm².

19. The method for making the thin film solar cell of claim 15, **characterized in that**, a height of the convex structure is in a range from 10 nm to 500 nm.

20. The method for making the thin film solar cell of claim 19, **characterized in that**, the height of the convex structure is in a range from 20 nm to 200 nm.
